# EUROPEAN PATENT SPECIFICATION

(11) **EP 2 816 591 B1**
(45) Date of publication and mention of the grant of the patent: **15.01.2020**
(21) Application number: 13749895.2
(22) Date of filing: 08.02.2013
(51) Int. Cl.: H01L 23/36, H01L 23/40, H05K 7/20, H01L 23/467

(54) **ELECTRICAL COMPONENT COOLING DEVICE AND HEAT SOURCE EQUIPMENT FOR A REFRIGERATION CYCLE APPARATUS PROVIDED WITH SAME**
VORRICHTUNG ZUR KÜHLUNG ELEKTRISCHER BAUTEILE SOWIE DAMIT AUSGESTATTETE WÄRMEQUELLENAUSSTATTUNG FÜR EINE KÄLTEKREISLAUFVORRICHTUNG
DISPOSITIF DE REFROIDISSEMENT DE COMPOSANT ÉLECTRIQUE ET ÉQUIPEMENT DE SOURCE DE CHALEUR POUR UN APPAREIL À CYCLE DE RÉFRIGÉRATION ÉQUIPÉ DE CE DISPOSITIF

(30) Priority: 14.02.2012 JP 2012029036
(43) Date of publication of application: 24.12.2014
(73) Proprietor: Toshiba Carrier Corporation, Kawasaki-shi Kanagawa 212-8585 (JP)
(72) Inventor: HAYASAKA, Yasuharu, Shizuoka-ken 416-8521 (JP); TAKADA, Teppei, Shizuoka-ken 416-8521 (JP)
(74) Representative: Kramer Barske Schmidtchen Patentanwälte PartG mbB
(86) International application number: PCT/JP2013/053025
(87) International publication number: WO 2013/121999

(56) References cited:
- JP-A- H01 208 626
- JP-A- H01 208 626
- JP-A- 2002 111 262
- JP-A- 2004 039 700
- JP-A- 2006 100 803
- JP-A- 2008 028 311
- JP-A- 2008 028 311
- JP-A- 2010 145 054
- JP-A- 2010 196 926
- JP-A- 2010 196 926
- JP-A- 2011 142 131

## Description

### Technical Field

The present invention relates to a cooling device for an electronic component and a heat source equipment for a refrigeration cycle apparatus including the cooling device.

### Background Art

In a known technology, for cooling an electronic component that generates heat, the electronic component is attached to a heat sink formed of a material excellent in heat radiation performance such as an aluminum material. For example, in an inverter device that drives a compressor contained in an outdoor unit of an air conditioner, a switching element package containing switching elements that generate heat in one package is attached to the heat sink, and heat radiation fins constituting a heat radiation section of the heat sink are cooled by wind-blow by a fan of the outdoor unit.

In general, as the switching elements used for the above-mentioned inverter device, six switching elements for three phases are contained in one package. A plurality of input terminal pins extending outside laterally from the package are soldered on a printed circuit board, and a control circuit and a power supply disposed on the printed circuit board are coupled to the switching elements via these input terminals. Further, it is to be noted that the switching elements are generally constituted of IGBTs and MOS-FETs.

It is necessary for external electroconductive components to be separated physically by a predetermined distance from electroconductive patterns and the like through which current flows on the printed circuit board and electric/electronic components mounted on the printed circuit board in order to secure electric insulation therebetween.

In the electronic component with a configuration in which a heat sink is attached thereto as mentioned above, a distance is shortest between the heat sink and the terminal pins extending laterally from the switching element package. Therefore, in order to secure a predetermined distance, there has been considered a method in which a sub-heat sink having the same shape as that of the switching element package and being made of material excellent in thermal conductivity such as aluminum material is interposed between the heat sink and the switching element package to ensure a separation from the original heat sink in distance.

### Prior Art Documents

### Patent Document

Patent Document 1: Japanese Patent Laid-open Publication No. JP2008071854

The document JP2002111262 discloses an electronic component cooling device including a thermal radiation plate which is mounted on a substrate board. The document JP2008028311 discloses a semiconductor device with a structure easy to construct for ensuring a predetermined distance in space and creepage distance between a cooling fin and an external terminal.

### Summary of the Invention

### Problems to be Solved by the Invention

However, it is also necessary for the sub-heat sink to secure an insulation distance from the terminal pins of the switching element package. According to such necessity, it is obliged for the sub-heat sink to have an outer shape smaller than that of the switching element package to some extent. Moreover, in order to secure an insulation distance between the terminal pins of the switching element package and the original heat sink, it is also necessary for the sub-heat sink to have a thickness not less than the insulation distance.

In order to solve the defect mentioned above, it becomes necessary for the sub-heat sink to have a thickness not less than the insulation distance, and hence, even if thermal conductivity of the sub-heat sink is high, thermal conduction performance becomes poor by an amount corresponding to the thickness.

Furthermore, for the above-mentioned reason, the sub-heat sink is configured to have the outer shape slightly smaller than that of the switching element package, and accordingly, a contact area between the original heat sink and the sub-heat sink becomes small and an amount of thermal conduction from the switching element package to the original heat sink also becomes small, which causes the heat radiation of the switching element package to be insufficient, thus providing a problem.

The present invention was conceived in consideration of the circumstances mentioned above, and an object thereof is to provide a cooling device for an electric component which can attain sufficient heat radiation and is excellent in thermal conductivity and reliability.

Moreover, another object of the present invention is to provide a heat source equipment for a refrigeration cycle apparatus which includes the cooling device having the above-mentioned advantages, and thereby, attains high reliability and excellent safety.

### Means for Solving the Problems

The above objects can be achieved according to one embodiment of the present invention by providing a cooling device for an electronic component as recited in claim 1.

The above objects can be also achieved according to another embodiment of the present invention by providing a heat source equipment for a refrigeration cycle apparatus including the cooling device for an electronic component according to claim 1, the heat source equipment as recited in claim 2.

It may be desired that the electronic component is a semiconductor used for an inverter device that drives the compressor.

It may be preferred that the refrigeration cycle apparatus is an outdoor unit of an air conditioner.

According to the cooling device for an electronic component of the embodiment of the present invention having the structural features described above, it is possible to provide a cooling device for an electric component, enabling sufficient heat radiation and providing excellent thermal conductivity and high reliability.

Moreover, since the heat source equipment for a refrigeration cycle apparatus is provided with such cooling device for an electric component, it can provide high reliability.

### Brief Description of the Drawings

[Fig. 1] is a perspective view of an outdoor unit of an air conditioner in which a cooling device for an electronic component according to an embodiment of the present invention is applied.
[Fig. 2] is an exploded perspective view illustrating a state of assembly of the cooling device illustrated in Fig. 1.
[Fig. 3] presents an elevation view (Fig. 3A) of a sub-heat sink used for the cooling device illustrated in Fig. 1 and a cross-sectional view (Fig. 3B) thereof taken along the line IIIB-IIIB in Fig. 3A.
[Fig. 4] is a top side view of the cooling device illustrated in Fig. 1.

### Embodiment for carrying out the Invention

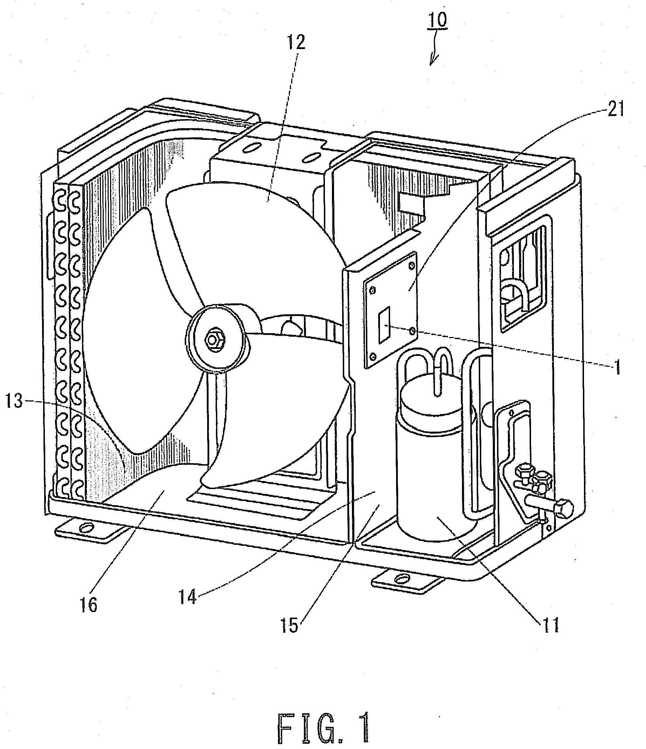

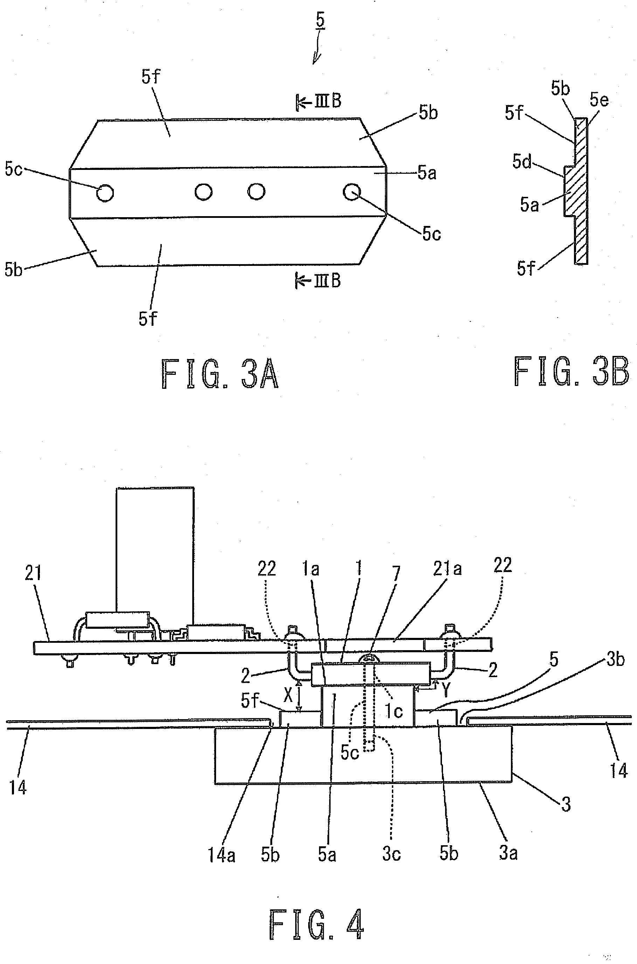

Hereafter, an embodiment according to the present invention will be described with reference to the accompanying drawings of Fig. 1 and Fig. 4. More specifically, a cooling device for an electronic component according to an embodiment of the present invention and a heat source equipment for a refrigeration cycle apparatus including the cooling device are described by taking an outdoor unit 10 of an air conditioner as an example.

Further, it is to be noted that, in the following description of the embodiment, terms representing directions such as upper/lower, right/left and the like terms are described based on an illustrated state or an actually installed state.

Fig. 1 illustrates the outdoor unit 10 of the air conditioner in a state in which a front surface side panel thereof is removed. In the outdoor unit 10, a compressor 11, an outdoor fan 12 and an outdoor heat exchanger 13 are contained. The inside of the outdoor unit 10 is partitioned into two sections of a machine chamber 15 containing the compressor 11 and a heat exchanger chamber 16 containing the outdoor fan 12 and the outdoor heat exchanger 13 by a partitioning plate 14 formed of a metal plate.

In the machine chamber 15, in addition, in the compressor 11, a three-phase inverter device that drives the compressor 11 at a variable speed is housed. The inverter device is constituted of a printed circuit board 21 to which a switching element package 1 is electrically coupled. The switching element package 1 is an electronic component containing six switching elements that generate heat such as IGBTs and MOS-FETs in one package having a substantially rectangular shape.

On the printed circuit board 21, in addition to the switching element package 1A, a control circuit including a microcomputer that controls ON/OFF states of the switching elements in the package 1 and a peripheral circuit for the microcomputer, and a power supply circuit for the inverter device are mounted. Although the outer periphery of the printed circuit board 21 is normally covered with an electric component container box, the electric component container box is removed in the illustration for the sake of description.

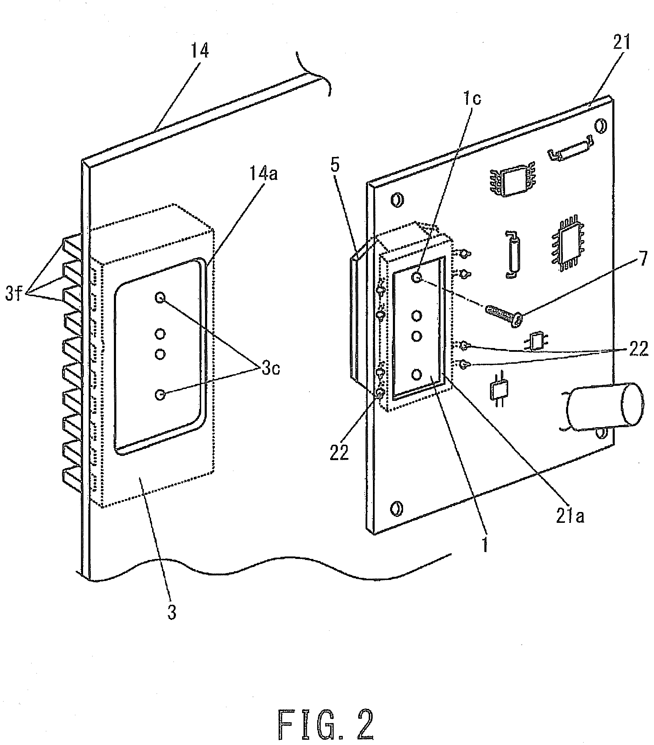

As shown in Fig. 2 in an enlarged scale, the switching element package 1, which is the electronic component, has a rectangular shape thin in thickness and is disposed on a rear surface side of the printed circuit board 21, in which the longitudinal direction thereof is set as a vertical direction. Input/output terminal pins 2 extend from right and left side surfaces of the switching element package 1 in a short-side direction thereof. The input/output terminal pins 2 are bent at tip ends toward the printed circuit board side, penetrate holes 22 formed in the printed circuit board 21 and are soldered on a front surface side of the printed circuit board 21. It is further noted that, in the following description of the printed circuit board 21 and the switching element package 1, surfaces facing the compressor (11) side are referred to as front surface side and surfaces facing the heat exchanger (16) side are referred to as back surface side in the installed (i.e., mounted) state of these components.

Various electronic elements and electric component elements constituting the control circuit and the power supply circuit for the inverter device are soldered on the front surface side of the printed circuit board 21. Various circuits provided on the front surface side of the printed circuit board 21 are electrically coupled to the input/output terminal pins 2 of the switching element package 1 by means of embedded wires (copper foils) provided on the printed circuit board 21. An opening 21a having dimension slightly smaller than that of the switching element package 1 is provided in the printed circuit board 21 at a position opposing to an attachment position of the switching element package 1. Therefore, the switching element package 1 can be visually observed through the opening 21a from the front surface side of the printed circuit board 21.

On the heat exchanger chamber 16 side of the partition plate 14 illustrated in Fig. 1, a main heat sink 3 is attached to be fixed to the partition plate 14 with not-shown screws or the like from the heat exchanger chamber 16 side. In the following description of the main heat sink 3, a front side refers to its surface on the machine chamber 15 side and a backside refers to its surface on the heat exchanger chamber 16 side.

As illustrated in Fig. 2, an opening 14a is provided in the partition plate 14 at a position corresponding to a center portion of the main heat sink 3 on the front side thereof. A front side surface of the main heat sink 3 is formed to be flat as a heat absorption surface 3b. The main heat sink 3 is attached so that the front side surface thereof closes the opening 14a. Although rainwater may enter the heat exchanger chamber 16 through the outdoor heat exchanger 13, the front side surface of the main heat sink 3and the opening 14a are sealed with a sealing material such as an adhesive therebetween such that the rainwater does not flow into the machine chamber 15 through the opening 14a.

The main heat sink 3 is formed by extrusion molding of an aluminum material high in thermal conductivity, and on a surface on its backside, a plurality of fins 3f are arranged to stand for increasing a contact area with open air on the heat exchanger chamber 16 side to enhance heat radiation performance. A main body of the main heat sink 3 and the fins 3f are integrally formed of an aluminum material high in thermal conductivity and are obtained by extrusion molding in a longitudinal direction of the fins 3f. A surface on which the plurality of fins 3f are arranged to stand is a heat radiation section 3a and an opposite side (front side) to the heat radiation section 3a is a planar heat absorption surface 3b.

When the air conditioner is operated, wind blows the fins 3f according to the operation of the outdoor fan 12 in the heat exchanger chamber 16 to thereby radiate outward the heat of the main heat sink 3. The fins 3f extend in a horizontal direction from the rear surface side of the switching element package 1 to be perpendicular to a longitudinal direction of the switching element package 1.

A metal plate having high heat radiation performance is embedded in an opposite surface (rear surface), of the switching element package 1 as an electronic component generating heat, to the printed circuit board 21 so as to form a heat radiation surface 1a (see Fig. 4). A sub-heat sink 5 is provided between the heat radiation surface 1a of the switching element package 1 and the main heat sink 3 so as to communicate from the machine chamber 15 with the heat exchanger chamber 16 via the opening 14a formed in the partition plate 14. The sub-heat sink 5 is formed as an integrally molded article of an aluminum material having high thermal conductivity similarly to the main heat sink 3.

Fig. 3 illustrates an elevation view (Fig. 3A) of the sub-heat sink 5 and a cross-sectional view (Fig. 3B) thereof taken along the line IIIB-IIIB.

The sub-heat sink 5 has a rectangular shape in which a right/left direction is a short-side direction and a front/rear direction is a longitudinal direction and has a stepwise shape, that is, a convex shape, in cross-section, composed of an upper stage portion 5a and a lower stage portion 5b. The upper stage portion 5a includes a flat upper surface 5d which has a rectangular shape and is in close contact with and fixed to the heat radiation surface 1a of the switching element package 1. Meanwhile, a lower surface of the lower stage portion 5b, that is, a backside end surface 5e of the sub-heat sink 5 is also a flat and smooth surface and this backside end surface 5e is in close contact with and fixed to the heat absorption surface 3b of the main heat sink 3.

Between a position apart, by a predetermined distance, from the upper stage portion 5a toward the backside end surface (5e) side and the backside end surface 5e, lower stage sub-portions 5b, 5b extending in the short-side direction are provided on both side surfaces of the sub-heat sink 5 in the short-side direction. Each of the right and left lower stage sub-portions 5b, 5b provides a trapezoidal shape in a front view (Fig. 3A)). A height of the trapezoid, that is, an extending length of each of the lower stage sub-portions 5b, 5b from the upper stage portion 5a is substantially the same as a length of the upper surface 5d in the short-side direction. Therefore, the backside end surface 5e of the sub-heat sink 5 has a substantially the same length as that of the upper stage portion 5a thereof in the longitudinal direction and has substantially three times a length of the upper surface 5d of the upper stage portion 5a in the short-side direction. Accordingly, an area of the backside end surface 5e is substantially three times as large as that of the upper surface 5d of the upper stage portion 5a, largely increasing a contact (thermal conduction) area of the sub-heat sink 5 with the main heat sink 3.

The length of the upper surface 5d of the upper stage portion 5a in the short-side direction is formed to be slightly shorter than the length of the switching element package 1 in the short-side direction and the upper surface 5d gets into the switching element package 1. According to this configuration, the upper surface 5d of the upper stage portion 5a does not face the terminal pins 2, and the terminal pins 2 are apart from end portions of the upper surface 5d of the upper stage portion 5a by a predetermined distance Y illustrated in Fig. 4. Accordingly, a creeping distance Y from the input/output terminal pins 2 of the switching element package 1 to the upper surface 5d of the upper stage portion 5a of the sub-heat sink 5 is set to a predetermined insulation distance determined in accordance with a current flowing through the input/output terminal pins 2 and/or a voltage, thereby preventing discharge between the input/output terminal pins 2 and the upper stage portion 5a of the sub-heat sink 5 from causing.

In a center portion of the sub-heat sink 1 in the short-side direction, four through holes 5c are provided to be lined up in the longitudinal direction (Fig. 3A) so as to penetrate the upper stage portion 5a and the lower stage portion 5b. The through holes 5c are symmetrically arranged in front/rear (longitudinal) direction and right/left (short-side) direction. Accordingly, it is only necessary to confirm upward or downward position in an assembling operation and not necessary to confirm any of the front/rear direction and the right/left direction, thus enhancing operation efficiency.

As illustrated in Fig. 4, when the switching element package 1, the sub-heat sink 5 and the main heat sink 3 are fixed one another in an overlapped manner, the upper surfaces 5f of the lower stage portion 5b oppose to the input/output terminal pins 2 of the switching element package 1. Since the upper stage portion 5a protrudes from the lower stage portion 5b by a predetermined height, a spatial distance X between the input/output terminal pins 2 of the switching element package 1 and the upper surfaces 5f of the lower stage portion 5b of the sub-heat sink 5 is secured as shown in Fig. 4.

Accordingly, the spatial distance X between the input/output terminal pins 2 of the switching element package 1 and the upper surfaces 5f of the lower stage portion 5b of the sub-heat sink 5 is set to be separated by a predetermined insulation distance in accordance with a current flowing through the input/output terminal pins 2 and/or a voltage applied thereto, thus preventing the discharge between the input/output terminal pins 2 and the lower stage portion 5b from causing.

A plurality of through holes 1c are formed in the switching element package 1 at positions corresponding to the through holes 5c of the sub-heat sink 5. Furthermore, holes 3c for screw-fastening are also similarly formed in the main heat sink 3 at positions corresponding to the through holes 5c of the sub-heat sink 5.

By positioning the through hole 1c of the switching element package 1, the through hole 5c of the sub-heat sink 5 and the screw fastening hole 3c of the main heat sink 3 in an alignment on one straight line, as illustrated in Figs. 2 and 4, a screw 7 is allowed to pass through the two through holes 1c and 5c and fastened into the screw fastening hole 3c. Thus, the switching element package 1, the sub-heat sink 5 and the main heat sink 3 are integrally fixed to one another tightly.

Further, the backside end surface 5e of the sub-heat sink 5 is formed to have an area smaller in dimension than that of the opening 14a formed in the partition plate 14. The sub-heat sink 5 and the main heat sink 3 are fixed to each other at a portion inside the opening 14a.

Furthermore, the thermal conductivity between the heat radiation surface of the switching element package 1 and the upper surface 5d of the upper stage portion 5a of the sub-heat sink 5 and between the backside end surface 5e of the sub-heat sink 5 and the heat absorption surface 3b of the main heat sink 3 can be further improved by applying heat conductive grease on the upper surface 5d of the upper stage portion 5a and the backside end surface 5e in the sub-heat sink 5 before the screw fasting operation.

As mentioned above, the area of the backside end surface 5e of the sub-heat sink 5 is enlarged to be larger than the area of the upper surface 5d of the upper stage portion 5a by those of the lower stage sub-portions 5b, 5b which extend from the side faces in the right/left direction. According to such configuration, a heat conduction area between the sub-heat sink 5 and the main heat sink 3 is enlarged. Furthermore, since the sub-heat sink 5 that is integrally formed, the inside of the sub-heat sink 5 can provide a smooth heat flux distribution. In addition, the heat from the switching element package 1 is sufficiently transmitted to the backside end surface 5e positioned in the lower portion of the lower stage portion 5b. As a result, the heat generated by the switching element package 1 during the operation can be efficiently transmitted to the main heat sink 3 via the sub-heat sink 5, enabling sufficient heat radiation. Accordingly, a cooling device for an electronic component attaining high cooling performance can be provided.

Moreover, the input/output terminal pins 2 provided on the side surfaces of the switching element package 1 and the lower stage portion 5b are arranged with the spatial distance X, which is predetermined. Furthermore, the input/output terminal pins 2 and the upper stage portion 5a are also with the creeping distance Y, which is predetermined. Therefore, the cooling device having high reliability and high safety performance can be provided without causing discharge to the sub-heat sink 5, even when the switching elements are in an energized state, and thus, the malfunction can be prevented from arising.

Further, it is to be noted that the spatial distance X and the creeping distance Y are set relative to an input/output terminal pin 2 to which the highest voltage is applied among all the input/output terminal pins 2.

Moreover, the length of the upper stage portion 5a in the short-side direction is equal to or smaller than the length of the switching element package 1 in the short-side direction. Accordingly, the front side end surface 5d of the upper stage portion 5a does not oppose to the input/output terminal pins 2, and even in an energized state of the switching elements, the discharge to the front side end surface 5d of the sub-heat sink 5 does not arise, thereby attaining electrically high reliability.

Furthermore, since the switching element package 1 and the main heat sink 3 are overlapped to be fixed to each other via the above-mentioned sub-heat sink 5, an amount of thermal conduction from the switching element package 1 to the main heat sink 3 can be secured sufficiently. Moreover, since the input/output terminal pins 2 are apart from the main heat sink and the sub-heat sink 5 by a necessary distance, the discharge from the input/output terminal pins 2 can be prevented from arising. Thus, the cooling device for an electric component having excellent thermal conductivity and high reliability can be provided.

Moreover, an outdoor unit, of an air conditioner, which is a heat source equipment for a refrigeration cycle apparatus can be provided to be safe and high in reliability by including this cooling device for an electric component.

More specifically, in the case in which an outdoor unit of an air conditioner is constructed as heat source equipment, the compressor 11, the outdoor fan 12 and the outdoor heat exchanger 13 are contained in the outdoor unit 10 as illustrated in Fig. 1 in the described embodiment. The inside of the outdoor unit 10 is partitioned by the partition plate 14 molded from a metal plate into two chambers including the machine chamber 15 containing the compressor 11 and the heat exchanger chamber 16 containing the outdoor fan 12 and the outdoor heat exchanger 13.

It is further to be noted that in the above-mentioned embodiment, as a heat source equipment for a refrigeration cycle apparatus, an outdoor unit for an air conditioner is exemplarily represented, but the heat source equipment may be used for other refrigeration cycle apparatus such as a heatpump hot-water supply system, a chiller and the like.

In the described embodiment, although the lower stage portion 5b of the sub-heat sink 5 is formed so as to extend in the short-side direction of the upper stage portion 5a, it may be formed so as to extend in the longitudinal direction thereof.

Moreover, in the embodiment described above, although one switching element package 1 which is a single electronic component that generates heat is provided for one sub-heat sink 5, a plurality of element packages may be fixed to one sub-heat sink.

Furthermore, as apparent from Fig. 3, although the cross-sectional shape of the sub-heat sink 5 according to the described embodiment is constituted of two stages of planar surfaces, the shape is not limited to such cross sectional shape, and the upper surface 5f of the lower stage portion 5b may be formed as an inclined surface or a curved surface as long as the necessary creeping distance and spatial distance are secured toward the input/output terminal pins 2.

### Reference Numeral

1 --- switching element package, 1a --- heat radiation surface, 1c --- through hole, 2 --- input/output terminal pin, 3 --- main heat sink, 3a --- heat radiation section, 3b --- heat absorption section, 3c --- screw fastening hole, 3f --- fin, 5sub-heat sink, 5a --- upper stage portion, 5b --- lower stage portion, 5c --- hole, 7 --- screw, 10 --- refrigerant cycle apparatus, 11 --- compressor, 12 --- outdoor fan, 13 --- heat exchanger, 14 --- partition plate, 14a --- opening, 15machine chamber, 16 --- heat exchanger chamber, 21printed circuit board.

## Claims

1. A cooling device for an electronic component, comprising:
an element package (1) having a rectangular shape, accommodating an electronic component that generates heat and including a heat radiation surface (1a) that is configured to radiate the heat generated by the electronic component;
a terminal pin (2) extending from a side surface of the element package (1);
a main heat sink (3) including a heat radiation section having a plurality of heat radiation fins (3f) arranged in a standing manner, and a flat heat absorption surface (3b) positioned on a side opposite to the side of the heat radiation section as a side on which the element package (1) is mounted; and
a sub-heat sink (5) which is provided between the element package (1) and the main heat sink (3) and has a shape in which an upper stage (5a) and a lower stage (5b) are integrally formed into a stepwise shape in cross-section, the upper stage (5a) having an upper surface (5d) in contact with and fixed to the heat radiation surface (1a) of the element package (1) and the lower stage (5b) having a lower surface (5e) in contact with and fixed to the heat absorption surface (3b) of the main heat sink (3), wherein
an end portion of the upper surface (5d) of the upper stage (5a) and an upper surface (5f) of the lower stage (5b) in the stepwise shape in the sub-heat sink (5) are respectively positioned apart from the terminal pin (2) by a predetermined distance (X, Y).

2. A heat source equipment for a refrigeration cycle apparatus (10) including the cooling device for an electronic component according to claim 1, the heat source equipment comprising:
a machine chamber (15) in which a compressor (11) is disposed;
a heat exchanger chamber (16) in which a heat exchanger (13) and a fan (12) that is configured to blow wind to the heat exchanger (13) are disposed; and
a partition plate (14) that partitions the machine chamber (15) from the heat exchanger chamber (16), wherein
the partition plate (14) is provided with an opening (14a), the element package (1) is provided in the machine chamber (15), the main heat sink (3) is attached to a position at which the opening (14a) of the partition plate (14) is closed on a side of the heat exchanger chamber (16), and the sub-heat sink (5) is attached to the main heat sink (3) via the opening (14a) provided in the partition plate (14) from a side of the machine chamber (15).

3. The heat source equipment for a refrigeration cycle apparatus (10) according to claim 2, wherein the electronic component is a semiconductor used for an inverter device that drives the compressor (11).

4. The heat source equipment for a refrigeration cycle apparatus (10) according to claim 2, wherein the refrigeration cycle apparatus (10) is an outdoor unit of an air conditioner.

## Patentansprüche

1. Kühlungsvorrichtung für eine elektronische Komponente, mit:
einem Elementpaket (1) mit einer rechteckigen Form, das eine elektronische Komponente aufnimmt, die Wärme erzeugt, und eine Wärmeabstrahlungsoberfläche (1a) aufweist, die dazu ausgebildet ist, die Wärme, die durch die elektronische Komponente erzeugt wird, abzustrahlen;
einem Anschlussstift (2), der sich von einer seitlichen Oberfläche des Elementpakets (1) erstreckt;
einem Hauptkühlkörper (3), der einen Wärmeabstrahlungsbereich mit einer Mehrzahl von Wärmeabstrahlungslamellen (3f), die in einer stehenden Weise angeordnet sind, und eine flache Wärmeabsorptionsoberfläche (3b), die auf einer Seite entgegengesetzt zu der Seite des Wärmeabstrahlungsbereichs positioniert ist, als eine Seite, auf der das Elementpaket (1) montiert ist, aufweist; und
einem Unterkühlkörper (5), der zwischen dem Elementpaket (1) und dem Hauptkühlkörper (3) vorgesehen ist und eine Form aufweist, in der eine obere Stufe (5a) und eine untere Stufe (5b) integral in einer stufenweisen Form im Querschnitt ausgebildet sind, welche obere Stufe (5a) eine obere Oberfläche (5d) in Kontakt mit und befestigt an der Wärmeabstrahlungsoberfläche (1a) des Elementpakets (1) aufweist und welche untere Stufe (5b) eine untere Oberfläche (5e) in Kontakt mit und befestigt an der Wärmeabsorptionsoberfläche (3b) des Hauptkühlkörpers (3) aufweist, bei der
ein Endabschnitt der oberen Oberfläche (5d) der oberen Stufe (5a) und eine obere Oberfläche (5f) der unteren Stufe (5b) in der stufenweisen Form in dem Unterkühlkörper (5) respektive von dem Anschlussstift (2) um einen vorherbestimmten Abstand (X, Y) entfernt positioniert sind.

2. Wärmequellenausrüstung für eine Kältekreislaufeinrichtung (10) mit der Kühlungsvorrichtung für eine elektronische Komponente nach Anspruch 1, welche Wärmequellenausrüstung aufweist:
eine Maschinenkammer (15), in der ein Kompressor (11) angeordnet ist;
eine Wärmetauscherkammer (16), in der ein Wärmetauscher (13) und ein Ventilator (12), der dazu ausgebildet ist, Wind zu dem Wärmetauscher (13) zu blasen, angeordnet sind; und
eine Trennplatte (14), die die Maschinenkammer (15) von der Wärmetauscherkammer (16) abtrennt, bei der
die Trennplatte (14) mit einer Öffnung (14a) versehen ist, das Elementpaket (1) in der Maschinenkammer (15) vorgesehen ist, der Hauptkühlkörper (3) an einer Position, an der die Öffnung (14a) der Trennplatte (14) verschlossen wird, auf einer Seite der Wärmetauscherkammer (16) angebracht ist, und der Unterkühlkörper (5) an dem Hauptkühlkörper (3) über die Öffnung (14a), die in der Trennplatte (14) vorgesehen ist, von einer Seite der Maschinenkammer (15) angebracht ist.

3. Wärmequellenausrüstung für eine Kältekreislaufeinrichtung (10) nach Anspruch 2, bei der die elektronische Komponente ein Halbleiter ist, der für eine Wechselrichtervorrichtung, die den Kompressor (11) ansteuert, verwendet wird.

4. Wärmequellenausrüstung für eine Kältekreislaufeinrichtung (10) nach Anspruch 2, bei der die Kältekreislaufeinrichtung (10) eine Außeneinheit einer Klimaanlage ist.

## Revendications

1. Dispositif de refroidissement pour un composant électronique, comprenant :
un boîtier d'élément (1) ayant une forme rectangulaire, recevant un composant électronique qui génère de la chaleur et comprenant une surface de dégagement de chaleur (la) qui est configurée pour dégager la chaleur produite par le composant électronique ;
une broche-borne (2) s'étendant à partir d'une surface latérale du boîtier d'élément (1) ;
un puit de chaleur principal (3) comprenant une section de dégagement de chaleur comportant une pluralité d'ailettes de dégagement de chaleur (3f) agencées de manière debout, et une surface plate d'absorption de chaleur (3b) positionnée sur un côté opposé au côté de la section de dégagement de chaleur comme un côté sur lequel est monté le boîtier d'élément (1) ;
et
un puit de chaleur secondaire (5) qui est prévu entre le boîtier d'élément (1) et le puit de chaleur principal (3) et qui a une forme dans laquelle un étage supérieur (5a) et un étage inférieur (5b) sont formés intégralement en une forme de type à étage en section transversale, l'étage supérieur (5a) ayant une surface supérieure (5d) en contact avec et fixée à la surface de dégagement de chaleur (la) du boîtier d'élément (1), et l'étage inférieur (5b) ayant une surface inférieure (5e) en contact avec et fixée à la surface d'absorption de chaleur (3b) du puit de chaleur principal (3), où
une partie d'extrémité de la surface supérieure (5d) de l'étage supérieur (5a) et une surface supérieure (5f) de l'étage inférieur (5b) en forme de type à étage dans le puit de chaleur secondaire (5) sont respectivement positionnées de manière éloignées à une distance prédéterminée (X, Y) de la broche-bornes (2).

2. Équipement de source de chaleur pour un appareil de cycle frigorifique (10) comprenant le dispositif de refroidissement pour un composant électronique selon la revendication 1, l'équipement de source de chaleur comprenant :
une chambre de machine (15) dans laquelle est disposé un compresseur (11) ;
une chambre d'échangeur de chaleur (16) dans laquelle un échangeur de chaleur (13) et un ventilateur (12) qui est configuré pour souffler le vent vers l'échangeur de chaleur (13) sont disposés ; et
une plaque de séparation (14) qui sépare la chambre de machine (15) de la chambre d'échangeur de chaleur (16), dans laquelle la plaque de séparation (14) est munie d'une ouverture (14a), le boîtier d'élément (1) étant prévu dans la chambre de machine (15), le puit de chaleur principal (3) est attaché à une position dans laquelle l'ouverture (14a) de la plaque de séparation (14) est fermée sur un côté de la chambre d'échangeur de chaleur (16), et le puit de chaleur secondaire (5) est attaché au puit de chaleur principal (3) via l'ouverture (14a) prévue dans la plaque de séparation (14) depuis un côté de la chambre de machine (15).

3. Équipement de source de chaleur pour un appareil de cycle frigorifique (10) selon la revendication 2, dans lequel le composant électronique est un semi-conducteur utilisé pour un dispositif inverseur qui entraîne le compresseur (11).

4. Équipement de source de chaleur pour un appareil de cycle frigorifique (10) selon la revendication 2, dans lequel l'appareil de cycle frigorifique (10) est une unité extérieure d'un climatiseur.
